# EUROPÄISCHE PATENTSCHRIFT

(11) **EP 1 889 363 B1**
(45) Veröffentlichungstag und Bekanntmachung des Hinweises auf die Patenterteilung: **04.08.2010**
(21) Anmeldenummer: 06723537.4
(22) Anmeldetag: 18.03.2006
(51) Int. Cl.: H03K 3/537

(54) **VERFAHREN FÜR DEN KONTINUIERLICHEN, GETRIGGERTEN BETRIEB EINES MARX-GENERATORS INSBESONDERE VON MEHREREN MARX-GENERATOREN ZUR DRUCKREGELUNG UND ABBRANDDETEKTION IN DEN FUNKENSTRECKEN**
METHOD FOR THE CONTINUOUS TRIGGERED OPERATION OF A MARX GENERATOR, PARTICULARLY OF SEVERAL MARX GENERATORS, FOR PRESSURE REGULATION AND EROSION DETECTION IN THE SPARK GAPS
PROCEDE DE COMMANDE POUR LE FONCTIONNEMENT CONTINU ET DECLENCHEE PAR UN EVENEMENT D'UN GENERATEUR DE MARX EN PARTICULIER DE PLUSIEURS GENERATEURS DE MARX POUR CONTROLER LA PRESSION ET L'EROSION DANS UN ENSEMBLE D'ECLATEUR DANS UN TEL GENERATEUR

(30) Priorität: 07.06.2005 DE 102005025998
(43) Veröffentlichungstag der Anmeldung: 20.02.2008
(73) Patentinhaber: Karlsruher Institut für Technologie, 76131 Karlsruhe (DE)
(72) Erfinder: SACK, Martin, 76287 Rheinstetten (DE)
(86) Internationale Anmeldenummer: PCT/EP2006/002512
(87) Internationale Veröffentlichungsnummer: WO 2006/131162

(56) Entgegenhaltungen:
- US-A- 4 375 594
- US-A- 5 311 067
- US-A- 6 058 029

## Beschreibung

Die Erfindung betrifft ein Verfahren für den kontinuierlichen, getriggerten Betrieb eines Marx-Generators, insbesondere von mehreren Marx-Generatoren im optimalen Arbeitspunkt über einen längeren Zeitraum zur Druckregelung und Abbranddetektion in den Funkenstrecken der Marx-Generatoren.

Die Selbstdurchbruchspannung eines Marx-Generators hängt vom Funkenstreckenabbrand und vom Druck im Schalterturm ab. Bei einem getriggerten Betrieb mittels Überspannungstriggerung (siehe beispielsweise DE 103 20 425) ist es für einen geringen Zündverzug vorteilhaft, die Selbstdurchbruchspannung nur wenig oberhalb der gewünschten Ladeendspannung zu legen. Dazu muss bei feststehendem Funkenstreckenabstand der Druck im Funkenstrecken-/Schalterturm entsprechend angepasst werden. (Der Funkenstrecken-/Schalterturm ist das gleichartige Aneinanderreihen in einem zur Umgebung hin hermetisch abschließbaren, dielektrischen Rohr der für den Marx-Generator notwendigen Anzahl an Funkenstrecken. Das Rohr wird für den Betrieb mit einem Isoliergas bis zu einem vorgegebenen Druck gefüllt. Die beiden Kalotten einer Funkenstrecke stehen sich, in der Rohrwand eingebaut, mit vorgegebener Spaltbildung gegenüber.) Über der Betriebszeit unterliegen die Funkenstrecken einem Abbrand, wodurch sich der Abstand und damit die Selbstdurchbruchspannung erhöht. Dies muss durch Senken des Isoliergasdruckes ausgeglichen werden. Alternativ dazu ist das Nachstellen des Funkenstreckenabstands, also die Weite des Spalt bildenden Abstandes der zwei Kalotten einer Funkensstrecke. Während des getriggerten Betriebs kann die Selbstdurchbruchspannung jedoch nicht direkt gemessen werden. Auch die Messung des Funkenstreckenabbrands ist nicht ohne weiters möglich.

Bei repetierend betriebenen frei laufenden Marx-Generatoren mit geschlossenem Funkenstreckenturm wird der Druck im Funkenstreckenturm in Abhängigkeit von der gemessenen Ladespannung der Kondensatoren zum Zündzeitpunkt der gemessenen Ausgangsspannung, der Selbstdurchbruchspannung, oder des Ausgangsstroms nachgeregelt.

Bei getriggerten Marx-Generatoren mit offenem Funkenstreckenturm, wie sie für Prüftechnikzwecke zum Einsatz kommen, wird die Selbstdurchbruchspannung üblicherweise durch Abstands-/Spaltweitenverstellung der Funkenstrecken der Ladespannung angepasst. Im Falle einer automatischen Anpassung geschieht dies über eine im Gerät fest hinterlegte Kennlinie in Abhängigkeit von der eingestellten Ladespannung.

Bei der vorgesehenen Anwendung zur Elektroporation von Zuckerrüben arbeiten mehrere Marx-Generatoren nur über Dämpfungswiderstände entkoppelt auf eine gemeinsame Last. Ist sichergestellt, dass nur alle Marx-Generatoren gemeinsam zünden, können Verluste durch Randfelder im Elektroporationsbereich reduziert werden. Außerdem kann der Abstand der Zuleitungen mit geringerem Abstand zueinander aufgebaut werden. Ein probeweiser Betrieb der Generatoren im Selbstdurchbruch zwecks Druckeinstellung führte zu einer inhomogeneren Feldstärkeverteilung und einem höheren Einzelstrom. Zudem wird die Isolation der Leitungen zwischen Marx-Generator und Last stärker beansprucht. Eine Nachstellung während des Regelbetriebs ist daher nicht möglich.

Eine Nachstellung der Funkenstreckenabstände bzw. des Drucks abhängig von der Ladespannung nach einer festen Kennlinie, wie sie bei Prüftechnikgeneratoren üblich ist, berücksichtigt nicht den Funkenstreckenabbrand und die dadurch notwendige zusätzliche Nachregelung. Eine zusätzliche Einrichtung zur Messung des tatsächlichen Funkenstreckenabstands ist hierzu notwendig.

Der Erfindung liegt die Aufgabe zugrunde, eine Druck- bzw. Abstandsregelung an Schaltfunkenstrecken eines Marx-Generators sowie eine Abbranddetektion derselben durchzuführen.

Die Erfindung wird durch die Verfahrensschritte des Anspruchs 1 gelöst. Zur Triggerung wird an mindestens einer Funkenstrecke eines Marx-Generators eine mit der Zeit ansteigende Überspannung überlagert, die zum Durchbruch der Funkenstrecke führt. Der Überspannungswert wird zum Zeitpunkt des Durchbruchs bestimmt und zur Regelung des Drucks im Funkenstreckenturm und/oder des Abstandes der Kalotten herangezogen. Aus dem Zusammenhang zwischen Durchschlagspannung, Druck im Schalterturm und Abstand der Kalotten der getriggerten Funkenstrecke wird bei bekannter Durchschlagspannung und bekanntem Druck der Abstand bestimmt und zu einer Abbranddetektion herangezogen. Im Falle verstellbarer Kalotten erfolgt die Abbranddetektion auf der Grundlage einer Verschiebewegmessung in Ergänzung zu der Spannungs- und Druckmessung. Zur zeitlich definierten Auslösung mindestens zweier Marx-Generatoren wird der Zündverzug jedes Marx-Generators gemessen und werden die Triggersignale zeitlich so gestaffelt, dass die Ausgangsspannungen bzw. -ströme aller Marx-Generatoren innerhalb einer aufbaubedingten Streubandbreite zu den jeweils gewünschten Zeitpunkten ansteigen.

Bei der Überspannungstriggerung wird an einer Funkenstrecke beispielsweise mittels Impulsübertrager an einer Ladeinduktivität (Anspruch 5) oder kapazitiv (Anspruch 6) eine Überspannung angelegt. Aufgrund der Streukapazitäten des Marx-Generators und der Innenimpedanz der Quelle besitzt diese Spannung eine Anstiegszeit, die aufbaubedingt ist. Die Spannungsform ist eine gedämpfte Schwingung, die beim Ansprechen der Funkenstrecke in der Stirn abgeschnitten wird. Sie kann in diesem Bereich durch einen zeitlinearen Anstieg angenähert werden. Die momentane Spannung über der Funkenstrecke steht in einem definierten zeitlichen Zusammenhang zum Auslösezeitpunkt des Triggerimpulses. Durch eine Messung der Zeitdifferenz zwischen Triggerauslösung und Durchschlag der Funkenstrecke kann demnach auf die Durchschlagspannung der Funkenstrecke zurück geschlossen werden (Anspruch 3). Durch Mittelwertbildung über mehrere Zeitmessungen lässt sich die mittlere Selbstdurchbruchspannung bestimmen, die durch Druckverstellung oder Abstandsverstellung angepasst werden kann (Anspruch 2). Anders ausgedrückt: mittels Druck- oder Abstandsverstellung lässt sich für jede gewünschte Ladespannung im Auslegungsbereich der gleiche optimale Zeitverzug zwischen Triggerauslösung und Durchbruch der Funkenstrecke finden, was der optimalen Einstellung des Arbeitsdrucks oder -abstands entspricht.

Nach dem Paschen-Gesetz, das die statische Durchschlagspannung einer Funkenstrecke angibt, in Zusammenhang mit dem Flächen-Zeit-Gesetz nach Kind, nach dem die dynamische Überspannung abgeschätzt werden kann, kann aus der Durchschlagspannung und dem Druck auf den Abstand der Funkenstrecken und damit den Abbrand geschlossen werden. Ist der Druckregelbereich bzw. Nachstellbereich ausgeschöpft, müssen die Elektroden getauscht werden. Der ermittelte Funkenstreckenabstand kann daher zur abnutzungsabhängigen Bestimmung des nächsten Wartungszeitpunkts zum Austauschen der Funkenstrecken herangezogen werden. Wird der Funkenstreckenabstand automatisch nachgestellt, ist eine Messung des Nachstellwegs notwendig.

Üblicherweise hat die getriggerte Funkenstrecke einen etwas kleineren Abstand als die übrigen Funkenstrecken und bestimmt deshalb die Selbstdurchbruchspannung des Marx-Generators. Da alle Funkenstrecken vom gleichen Strom durchflossen werden, ist erwartungsgemäß auch der Abbrand gleich, so dass eine Messung an der getriggerten Funkenstrecke genügt.

Zur synchronen Auslösung mehrerer Marx-Generatoren muss der Zündverzug jedes Marx-Generators gemessen und die Triggersignale zeitlich so gestaffelt werden, dass die Ausgangsspannungen bzw. -ströme aller Generatoren innerhalb einer tolerablen Streubandbreite gleichzeitig ansteigen. Die Zündverzögerung eines Marx-Generators, d.h. die Zeit zwischen dem Zünden der ersten und der letzten Funkenstrecke hängt bei gegebenem geometrischen Aufbau (Streukapazitäten zum Bezugspotential, meist Erdpotential) vom Abstand der Funkenstrecken, vom Gasdruck im Schalterturm sowie von der statistischen Zündverzugszeit jeder Funkenstrecke ab. Durch eine Druckregelung bzw. Abstandsnachstellung wird der Effekt des Abbrands auf die Zündverzugszeit des Marx-Generators zwar in gewissem Rahmen kompensiert, abhängig von der erforderlichen Toleranz kann jedoch eine gestaffelte Auslösung nötig sein. Hierzu wird für jeden Marx-Generator getrennt die Zeit zwischen Triggerauslösung und Spannungs- bzw. Stromanstieg am Ausgang bestimmt, gemittelt und durch Veränderung der Triggerzeitpunkte die Generatorausgangssignale zueinander synchronisiert (Anspruch 2). Die statistische Zündverzugszeit der einzelnen Funkenstrecken kann bei Bedarf durch die Vorionisation mittels ionisierender Strahlung verringert werden, das ist eine Methode zur Vergleichmäßigung des Durchschlagverhaltens von freilaufenden Funkenstrecken (Anspruch 4).

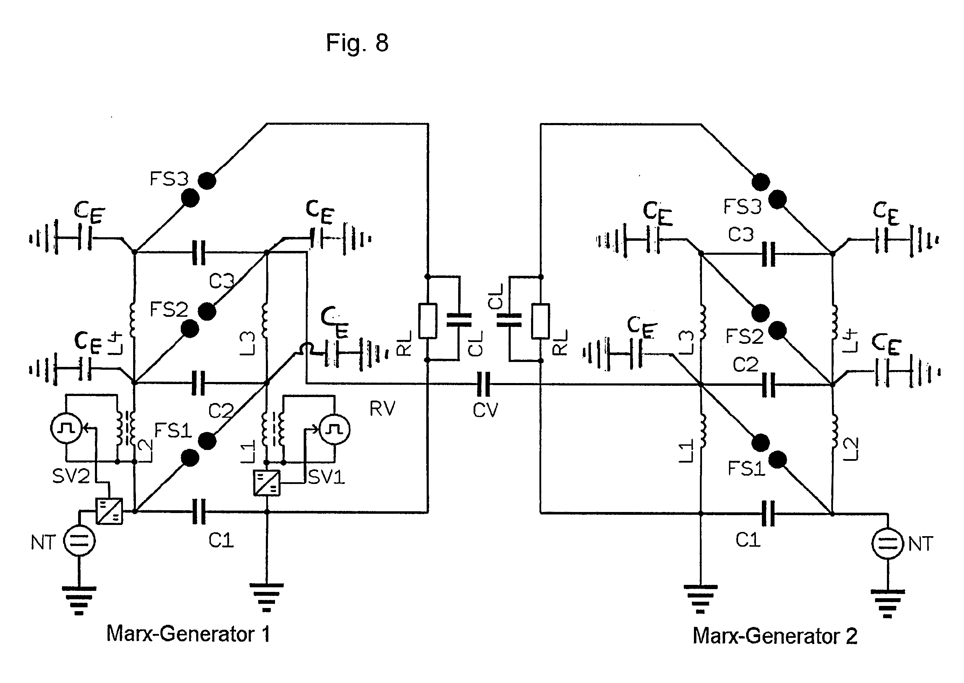

Nach Anspruch 8 kann die Überspannung durch den Aufladevorgang der Erdstreukapazitäten mindestens einer nachfolgenden Stufe in einem Marx-Generator hervorgerufen werden. Nach Anspruch 9 durch den Aufladevorgang des kapazitiven Anteils und/oder den ohmschen Anteil einer an den Ausgang des Marx-Generators angeschlossenen Lastimpedanz. Auch durch einen ohmschen Anteil der Lastimpedanz wird der Ausgang des Marx-Generators mit massenahem Potential verbunden, was zu einer Überspannung über der letzten Funkenstrecke führt. Bei einer Detektion des Zündzeitpunktes ist somit auch eine Überwachung des Funkenstreckenabstands der übrigen Funkenstrecken möglich. In der Figur 8 sind Erdstreukapazitäten sowie eine ohmsch-kapazitive Last eingezeichnet.

Zum Beobachten des Durchschaltens der Funkenstrecke haben sich optoelektronische Mittel bewährt, z.B. die Aufnahme der Helligkeitsänderung durch ein auf den Spalt der Funkenstrecke gerichteten Lichtleitfasereingang. Die Lichtleitfaser endet an einer Photodiode (Anspruch 10). Eine elektrische Variante ist in Anspruch 11 beschrieben, nämlich dass das Durchschalten einer Funkenstrecke kapazitiv mittels Koppelkondensator ausgekoppelt und weiterverarbeitet wird.

Neu an der Erfindung ist:
- die Bestimmung der Selbstdurchbruchspannung einer Funkenstrecke des Marx-Generators beim Anlegen eines Triggerimpulses durch Messung der Zeit zwischen Impulsanfang bzw. Auslöseimpuls für den Trigger und Funkenstreckendurchbruch;
- die Regelung des Stickstoffdrucks im Schalterturm bzw. des Funkenstreckenabstands derart, dass die Selbstdurchbruchspannung nur wenig oberhalb der Ladespannung liegt, wobei die mittlere gemessene Zeit zwischen Triggerimpulsbeginn und Funkenstreckendurchbruch als Regelgröße dient;
- die Bestimmung des Funkenstreckenabbrands aus der mittels Zeitmessung bestimmten Durchschlagspannung und dem Druck im Schalterturm bzw. der Wegmessung einer evtl. eingebauten Funkenstreckenverstellvorrichtung nach dem Paschengesetz;
- die Schätzung des Zeitraums bis zum nächsten abbrandbedingten Tausch der Funkenstrecken.

Damit werden folgende Vorteile erzielt:
- ein kontinuierlicher, getriggerter Betrieb insbesondere mehrerer Marx-Generatoren im optimalen Arbeitspunkt über einen längeren Zeitraum;
- ein einfacher Betrieb des Marx-Generators bei innerhalb der Auslegungsgrenzen frei wählbarer Ladespannung;
- eine planbare, abnutzungsabhängige Terminfestlegung für die nächste Wartung.

Die Erfindung wird im Folgenden anhand der Diagramme aus Versuchsergebnissen noch näher erläutert. Es zeigen:
- Figur 1: den Spannungsverlauf vor der Funkenstrecke der Stufe 2 bei einer Ladespannung von 30 kV/Stufe;
- Figur 2: die Lichtsignale der Funkenstrecke;
- Figur 3: den Spannungsverlauf vor der Funkenstrecke der Stufe 2 bei einer Ladespannung von 0 kV/Stufe;
- Figur 4: Triggerverzug an einem 7-stufigen Marx-Generator;
- Figur 5: Triggerverzug an einem 7-stufigen Marx-Generator;
- Figur 6: Marx-Generator mit Überspannungstriggerung der ersten Fun- kenstrecke;
- Figur 7: bipolar betriebener Marx-Generator;
- Figur 8: zwei Marx-Generatoren gleicher Polarität.

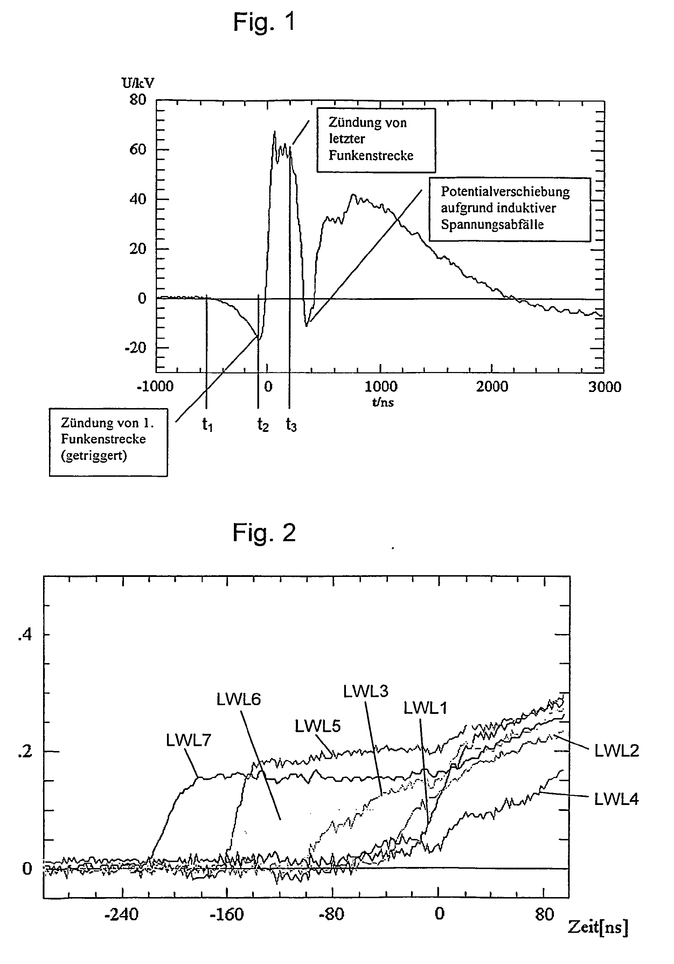

Figur 1 zeigt den Spannungsverlauf, vor der Funkenstrecke der Stufe 2 gemessen, gegenüber Masse. Der Marx-Generator wird zunächst parallel auf 30 kV/Stufe geladen. Ca. 500 ns von dem Durchbruch der ersten, getriggerten Funkenstrecke steigt bei t₂ die Spannung über der ersten Funkenstrecke zur Triggerung zu negativen Werten hin betragsmäßig an. Nachdem sie durchgeschaltet hat, steigt die Spannung an diesem Punkt auf doppelte Stufenspannung an, hier: 60 kV, hat also einen Nulldurchgang. Dieser Wert bleibt für ca. 300 ns konstant, bis der gesamte Marx-Generator also auch die letzte Funkenstrecke durchgeschaltet ist, d.h. alle Stufen zum Zeitpunkt t₃ durchgeschaltet sind. Sobald der Laststrom zu fließen beginnt, > t₃, bestimmt kurzzeitig die induktive Spannungsaufteilung der Lastschleife die Potentialverteilung und die gemessene Spannung bricht in diesem Beispiel auf Werte im negativen Bereich ein. Es findet vorübergehend eine Potentialverschiebung aufgrund induktiver Spannungsabfälle statt. Schließlich entlädt sich der Marx-Generator über den Lastwiderstand. Der Zeitablauf ist somit folgender:

| | |
|---|---|
| t₁ | Triggerauslösung; |
| t₁ - t₂ | Triggerspannungsaufbau über der getriggerten Funkenstrecke zusätzlich zur Ladespannung des Stufenkondensators, Ladung der Streukapazitäten des Marx-Generators; |
| t₂ | Zündung der ersten Funkenstrecke; |
| t₂ - t₃ | sukzessives Durchzünden der restlichen Funkenstrecken des Marx-Generators, Summenspannung zweier Stufen (60 kV) am Messpunkt; |
| t₃ | Durchzünden der letzten Funkenstrecke, Beginn des Laststromanstiegs; |
| > t₃ | Entladen des Marx-Generators über die Last, dabei zunächst Potentialverschiebung aufgrund induktiver Spannungsabfälle. |

Figur 2 zeigt das Diagramm des zeitlichen Durchzündverhaltens anhand der Lichtsignale der einzelnen Funkenstrecken, hier sieben Funkenstrecken, die mittels Lichtwellenleiter ausgekoppelt wurden. Zur Weiterverarbeitung werden die optischen Signale in elektrische gewandelt. Bereits während der Durchzündphase ist ein auswertbares Lichtsignal von der ersten Funkenstrecke zu erhalten, das zur Zeitbestimmung der Phase des Triggerspannungsaufbaus und damit zur Triggerspannungsmessung geeignet ist. Bereits bei den zur Zeit eingesetzte Marx-Generatoren dient das über Lichtwellenleiter aus der 1. Funkenstrecke ausgekoppelte Licht zur Zündüberwachung aber auch zur Notabschaltung im Fehlerfall. Eine optische Auskopplung ist also vorhanden und damit bietet sich die optische Signalerfassung an. Daneben können auch andere Methoden der Zündüberwachung für die genannte Zeitbestimmung geeignet sein, beispielsweise die kapazitive und damit elektrische Impulsauskopplung. Im Diagramm der Figur 2 bedeutet:

| | |
|---|---|
| LWL 7 | das Lichtsignal der ersten, getriggerten Funkenstrecke; |
| LWL 1 | das Lichtsignal der letzten Funkenstrecke; |
| t = 0 | ist der Beginn des Durchzündens der letzten Funkenstrecke und damit der Beginn des Laststromanstiegs. |

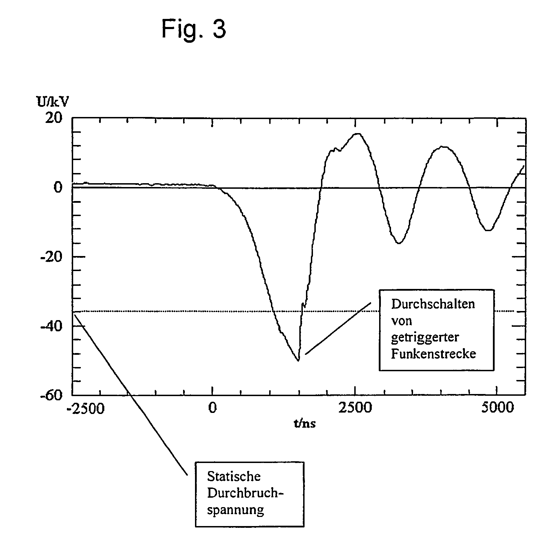

Figur 3 zeigt den Spannungsverlauf vor der Funkenstrecke der Stufe 2 gegenüber Masse, wenn nur die Triggerspannung anliegt, ohne dass die Kondensatoren des Marx-Generators geladen sind also ohne Ladespannung. Die statische Durchbruchspannung der Funkenstrecke liegt bei ca. 37 kV. Wegen der Zündverzugszeit und der Funkenaufbauzeit schlägt die Funkenstrecke bei einem schnellen Spannungsanstieg bei einer höheren Spannung als der statischen Durchbruchspannung durch (vgl. Flächen-Zeit-Gesetz nach Kind), im Beispiel sind es ca. 50 kV. Dies entspricht den Verhältnissen bei geladenem Marx-Generator; nach Figur 1 schlägt die Funkenstrecke bei -16 kV über, was bei einer Ladespannung von 30 kV einer Gesamtspannung von 46 kV entspricht.

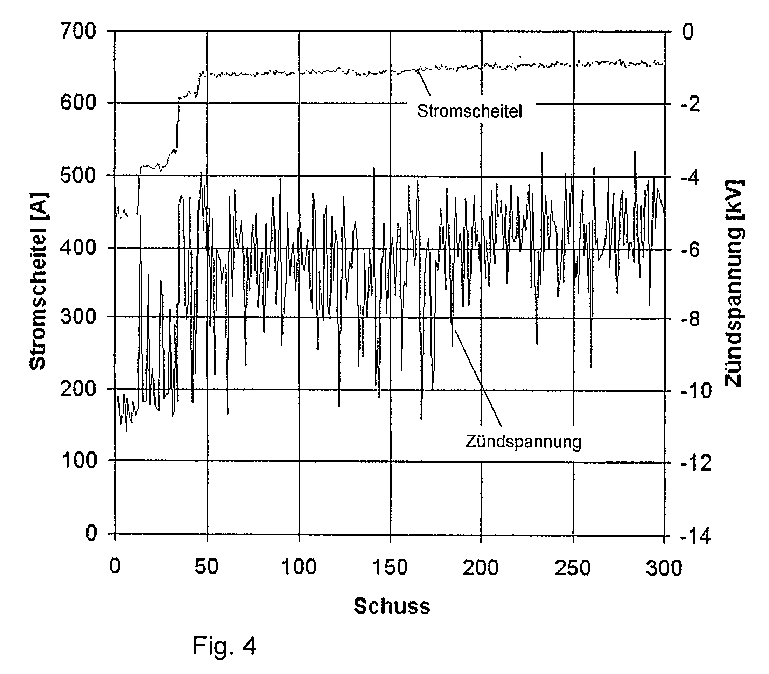

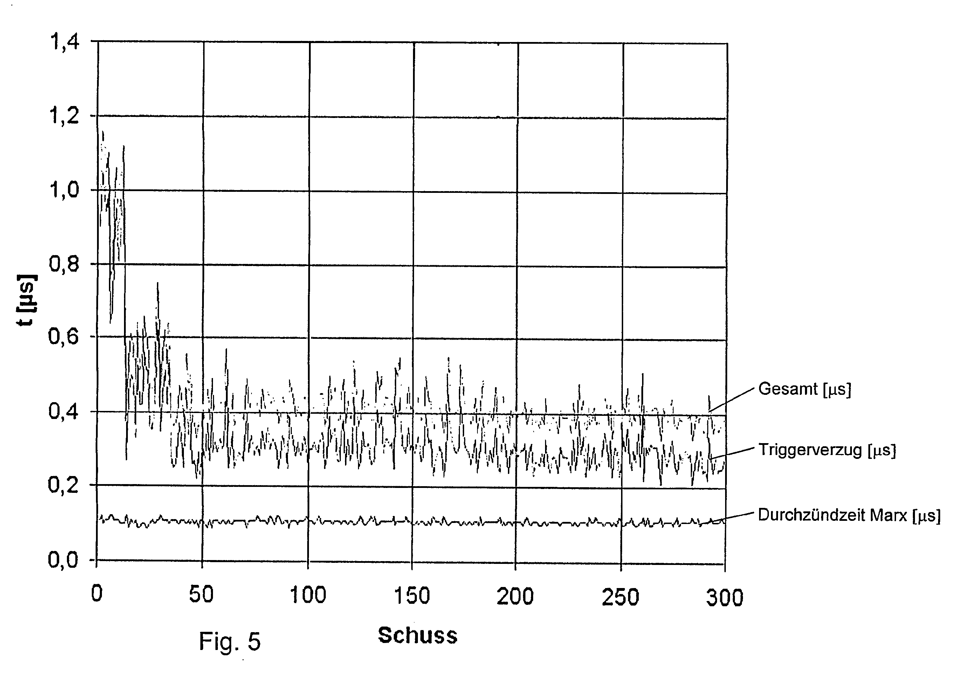

Die Figuren 4 und 5 zeigen für einen überspannungsgetriggerten 7-stufigen Marx-Generator den Triggerverzug, gemessen vom Spannungsanstieg der Triggerspannung bis zum Durchbruch der 1. Funkenstrecke, die Durchzündzeit des Marx-Generators, gemessen vom Durchschalten der ersten Funkenstrecke bis zum Beginn des Stromanstiegs an der Last, die gesamte Zündzeit als Summe der beiden vorgenannten Zeiten, die vom Überspannungstrigger gelieferte Zündspannung (Spannungsscheitel ohne den Ladespannungsanteil), sowie den Stromscheitel eines Teilstroms durch die Last (1/4 des Gesamtstroms) für die folgenden Betriebsfälle:

| **Ab Schuss-Nr.** | **Ladespannung pro Stufe** | **Ladestrom** | **Gasdruck** |
|---|---|---|---|
| 0 | 35 kV | 22,0 mA | 0,15 bar |
| 20 | 40 kV-50 kV | 22,0 mA-28,2 mA | 0,15 bar-0,50 bar |
| 50 | 50 kV | 28,2 mA | 0,50 bar |

Die Diagramme zeigen, wie die gemessene Zündspannung mit der Triggerverzugszeit korreliert. Bei optimaler Einstellung ergibt sich ab Schuss Nr. 50 ein Triggerverzug von ca. 300 ns entsprechend einem Mittelwert der Zündspannung von ca. -6 kV. Diese Werte wurden mit Vorionisation der getriggerten 1. Funkenstrecke (Anspruch 4) erzielt.

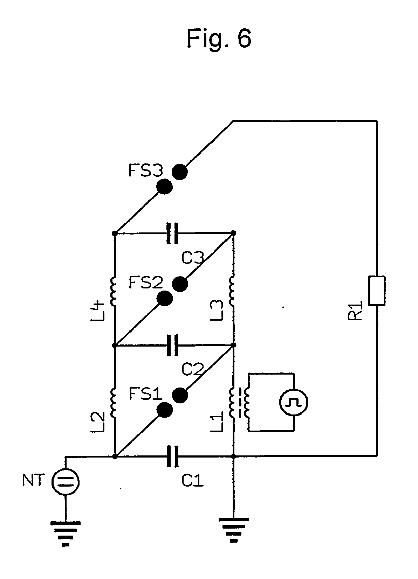

Figur 6 (siehe auch DE 103 20 425) zeigt beispielhaft einen dreistufigen Marx-Generator dessen erste Funkenstrecke FS1 gezielt durch den Impulsübertrager gezündet wird. Der vorgestellte Marx-Generator ist für den repetierenden Betrieb und deshalb mit den Ladespulen L1 bis L4 bestückt, die während der Aufladephase die Kondensatoren C1 bis C3 parallel schalten (siehe Figuren 1 bis 3). Hierbei ist beispielsweise die erdseitige Ladespule L1 zum Impulsübertrager ergänzt. Die durch diesen Übertrager erzeugte Spannung addiert sich zur Ladespannung des Kondensators der ersten Stufe und erzeugt bei geeigneter Polung die Überspannung an der Funkenstrecke FS1 dieser Stufe. Die Überspannung verhilft also zeitlich gezielt zum Selbstdurchbruch der Funkenstrecke FS1. Bei einer primären Pulsspannung geeigneter Höhe, hier beispielsweise 6 kV, zündet der Marx-Generator reproduzierbar unterhalb seiner statischen Zündspannung durch.

Wie bei nach herkömmlichen Methoden getriggerten Marx-Generatoren ist die statische Durchbruchspannung der Funkenstrecken auf ca. 5-10% oberhalb der Ladespannung der einzelnen Stufen eingestellt. Die Einstellung erfolgt gemäß der Paschen-Kurve wie üblich durch Variation des Elektrodenabstands und/oder des Gasdrucks in der Funkenstrecke. Nach dem Durchzünden der drei Funkenstrecken FS1 bis FS3 sind die Kondensatoren C1 bis C3 in Serie an die Last R1 geschaltet, über die sie sich im Hauptstrompfad entladen. Stromschwache Nebenentladungspfade führen über die Ladespulen L1 - L4. Der unterste Stufenkondensator C1 liegt auf Erdpotential als Bezugspotential. Während des Ladevorgangs werden alle drei Stufenkondensatoren C1, C2, C3 über das Netzteil NT auf die Stufenspannung von beispielsweise 50 kV über die Ladespulen L1 bis L4 mit einem ungeregelten anfangsbegrenzten Strom oder Konstantstrom von beispielsweise 300 mA aufgeladen.

In Figur 6 wird an der zum Impulsübertrager erweiterten Ladespule zum Zünden an der Eingangswicklung bei Speisung aus einer Spannungsquelle ein Spannungsimpuls von einem Dachwert von beispielsweise ca. 6 kV, bei einer anderen Auslegung zur Speisung aus einer Stromquelle ein Stromimpuls der innerhalb von beispielsweise ca. 300 nsec von beispielsweise 120 A auf 0 A absinkt, gelegt, der an der Ausgangswicklung des Impulsübertrager, der Ladespule, einen bis zum Durchbruch der Funkenstrecke ansteigenden Spannungsimpuls erzeugt.

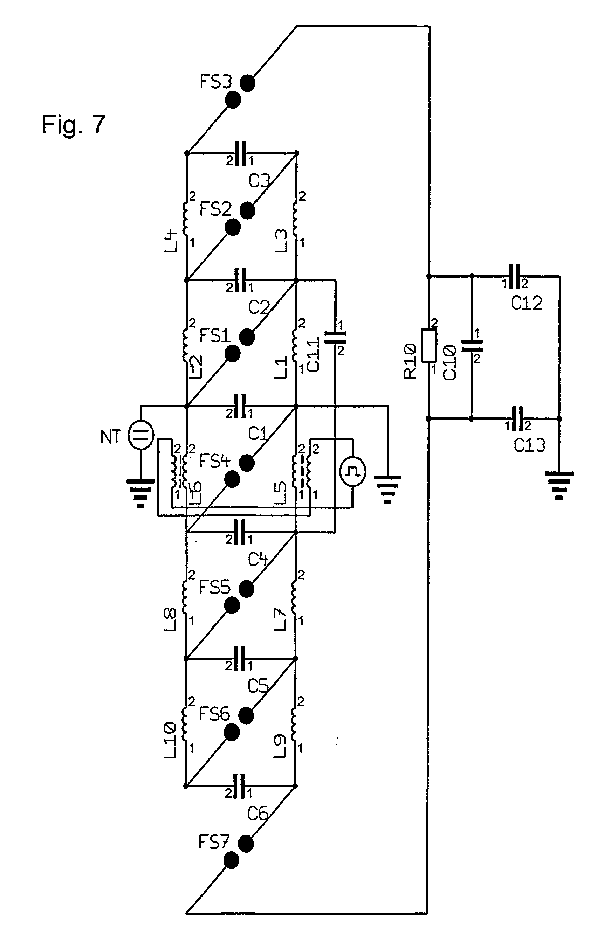

Figur 7 zeigt einen bipolar betriebenen Marx-Generator, der aus zwei Teilgeneratoren aufgebaut ist. Insbesondere bei einem bipolar betriebenen Marx-Generator kann eine Überspannungstriggerung der zweiten, nicht getriggerten Hälfte vorteilhaft über eine zusätzliche Kapazität erfolgen, die die beiden erdseitigen Stufen koppelt und jeweils die Anschlüsse Nr. 1 der Stufenkondensatoren C2 und C4 verbindet. Zunächst wird die erste Stufe der unteren Hälfte des Generators gezündet. Sobald die mit Masse direkt verbundene Funkenstrecke durchschaltet, verschiebt sich das Potential am Ausgang der 1. Stufe, an dem der Koppelkondensator angeschlossen ist, von Masse zu negativen Werten hin. Der Koppelkondensator überträgt diese Spannungsänderung an den Ausgang der ersten Stufe der oberen Generatorhälfte, so dass an der Funkenstrecke dieser Stufe eine Überspannung entsteht und diese Funkenstrecke durchschaltet. Die beiden Generatorhälften zünden dann wie üblich unabhängig voneinander durch. Die Koppelkapazität kann alternativ oder auch zusätzlich zwischen die Anschlüsse Nr. 2 der Kapazitäten C2 und C4 geschaltet werden. Durch die Serienschaltung eines Widerstands oder einer Induktivität kann die Spannungsänderung für eine bessere Messung moderat verlangsamt-werden.

Mehrere Generatoren gleicher Polarität können mittels einer Serienschaltung aus Kapazität und Widerstand zwischen den Ausgängen der beiden ersten Stufen gekoppelt sein, wie Figur 7 zeigt. Induktiv wird am ersten Generator eine Überspannung eingekoppelt, die über die Kondensator-Widerstandskombination auch auf den Ausgang der ersten Stufe des 2. Generators übertragen wird. Dabei muss durch eine Staffelung der Durchschlagspannungen gewährleistet sein, dass die Funkenstrecke des 2. Marx-Generators vor der des 1. Marx-Generators zündet, da beim Zünden des 1. Generators die Ausgangsspannung der 1. Stufe die Triggerspannung gegensätzlicher Polarität überlagert. Beim Zünden des 2. Generators verhindert der Widerstand eine frühzeitige Rückwirkung auf den Triggerpulsgenerator. Statt eines Widerstands kann auch eine Induktivität eingesetzt werden. Im Falle gleicher Stufenspannung kann auch auf den Kondensator verzichtet werden.

Figur 8 zeigt schließlich eine Variante mit zwei Generatoren gleicher Polarität, bei der eine Überspannung entgegengesetzter Polarität über der 1. Funkenstrecke dadurch erzeugt wird, dass eine Spannung von mindestens doppelter Stufenspannung an den Ausgang der 1. Stufe des 2. Marx-Generators eingekoppelt wird. diese Spannung wird dem Ausgang der 2. Stufe des 1. Generators mittels eines Koppelkondensators entnommen. Über den Ladungspumpeneffekt am Stufenkondensator der 2. Stufe an Marx 2 könnte allerdings die 2. Stufe des 2. Marx-Generator vor dessen erster Stufe zünden. Hier müssten geeignete Maßnahmen dagegen getroffen werden, beispielsweise indem L3 am ersten Marx-Generator genügend groß gewählt und für ein schnelles Durchschalten der Funkenstrecke FS2 am Marx-Generator 1 gesorgt wird.

## Patentansprüche

1. Verfahren für den kontinuierlichen, getriggerten Betrieb eines Marx-Generators insbesondere von mehreren Marx-Generatoren im optimalen Arbeitspunkt über einen längeren Zeitraum zur Druckregelung und Abbranddetektion, in den Funkenstrecken der Marx-Generatoren,
wobei die Funkenstrecken eines Marx-Generators in einen Schalterturm mit unter regelbarem Druck stehender Isoliergasatmosphäre eingebaut sind und/oder wenigstens eine Kalotte der beiden spaltbildenden Kalotten einer Funkenstrecke axial verstellbar ist,
bestehend aus den Schritten:
zur Triggerung wird an mindestens einer Funkenstrecke eines Marx-Generators eine mit der Zeit ansteigende Überspannung überlagert, die zum Durchbruch der Funkenstrecke führt,
der Überspannungswert zum Zeitpunkt des Durchbruchs wird bestimmt und zur Regelung des Drucks im Funkenstreckenturm und/oder des Abstandes der Kalotten herangezogen,
aus dem Zusammenhang zwischen Durchschlagspannung, Druck im Schalterturm und Abstand der Kalotten der getriggerten Funkenstrecke wird bei bekannter Durchschlagspannung und bekanntem Druck der Abstand bestimmt und zu einer Abbranddetektion herangezogen,
im Falle verstellbarer Kalotten erfolgt die Abbranddetektion auf der Grundlage einer Verschiebewegmessung in Ergänzung zu der Spannungs- und Druckmesssung ,
zur zeitlich definierten Auslösung mindestens zweier Marx-Generatoren wird der Zündverzug jedes Marx-Generators gemessen und werden die Triggersignale zeitlich so gestaffelt, dass die Ausgangsspannungen bzw. -ströme aller Marx-Generatoren innerhalb einer aufbaubedingten Streubandbreite zu den jeweils gewünschten Zeitpunkten ansteigen.

2. Verfahren nach Anspruch 1, **dadurch gekennzeichnet, dass** die gemessene Überspannung über mehrere Zündungen gemittelt wird und der gemittelte Wert statt eines Einzelmesswertes zur Abstandsbestimmung herangezogen wird.

3. Verfahren nach Ansprüchen 1 und 2, **dadurch gekennzeichnet, dass** die Überspannung statt einer Spannungsmessung durch die Messung der Zeitdifferenz zwischen Triggerauslösung und Funkenstreckendurchbruch bestimmt wird, wobei der zeitliche Spannungsverlauf bekannt ist.

4. Verfahren nach Ansprüchen 1 und 2, **dadurch gekennzeichnet, dass** die statistische Zündverzugszeit der einzelnen Funkenstrecken durch eine Vorionisation verringert wird.

5. Verfahren nach Ansprüchen 1 und 2, **dadurch gekennzeichnet, dass** die Überspannung induktiv mittels eines Übertragers in den Kreis eingekoppelt wird.

6. Verfahren nach Ansprüchen 1 und 2, **dadurch gekennzeichnet, dass** die Überspannung kapazitiv mittels einer Kapazität in den Kreis eingekoppelt wird.

7. Verfahren nach Anspruch 6, **dadurch gekennzeichnet, dass** als Spannungsquelle mindestens eine Stufe eines weiteren Marx-Generators verwendet wird.

8. Verfahren nach Anspruch 6, **dadurch gekennzeichnet, dass** die Überspannung durch den Aufladevorgang der Erdstreukapazitäten mindestens einer nachfolgenden Stufe in einem Marx-Generator hervorgerufen wird

9. Verfahren nach Anspruch 6, **dadurch gekennzeichnet, dass** die Überspannung durch den Aufladevorgang des kapazitiven Anteils und/oder des ohmschen Anteils einer an den Ausgang des Marx-Generators angeschlossenen Lastimpedanz hervorgerufen wird.

10. Verfahren nach einem der vorangehenden Ansprüche, **dadurch gekennzeichnet, dass** das Durchschalten einer Funkenstrecke optoelektronisch festgestellt wird.

11. Verfahren nach einem der vorangehenden Ansprüche, **dadurch gekennzeichnet, dass** das Durchschalten einer Funkenstrecke kapazitiv mittels Koppelkondensator ausgekoppelt und weiterverarbeitet wird.

## Claims

1. Method for the continuous triggered operation of a Marx generator, particularly several Marx generators, in the optimal operating point over an extended period of time for the purpose of pressure regulation and erosion detection in the spark gaps of the Marx generators,
wherein the spark gaps of a Marx generator are installed in a switching tower with insulating gas atmosphere under adjustable pressure and/or at least one cap of the two gap-forming caps of a spark gap is axially adjustable,
consisting of the steps:
for triggering, an overvoltage that increases with time is superposed on at least one spark gap of a Marx generator, said overvoltage leading to the breakdown of the spark gap,
the overvoltage value at the time of breakdown is determined and used to regulate the pressure in the spark gap tower and/or the distance of the caps,
the breakdown voltage and pressure being known, the distance is determined from the relation between the breakdown voltage, the pressure in the tower and the distance between the caps of the triggered spark gap, and used for erosion detection,
in the case of adjustable caps, erosion is detected from a measurement of the displacement path in addition to the voltage and pressure measurement,
the ignition delay of each Marx generator is measured for the purpose of a temporally defined triggering of at least two Marx generators, and the signals are triggered in a temporally graduated manner in such a way that the initial voltages or initial currents of all Marx generators increase within a structurally conditioned scattering range at the respective desired moments.

2. Method according to claim 1, **characterised in that** the measured overvoltage is averaged over several ignitions and the average value is used instead of an individual measurement value for determining the distance.

3. Method according to claims 1 and 2, **characterised in that**, instead of a voltage measurement, the overvoltage is determined by measuring the time difference between triggering and spark gap breakdown, the voltage time curve being known.

4. Method according to claims 1 and 2, **characterised in that** the statistical ignition delay time of the individual spark gaps is reduced by pre-ionisation.

5. Method according to claims 1 and 2, **characterised in that** the overvoltage is inductively applied to the circuit by means of a transformer.

6. Method according to claims 1 and 2, **characterised in that** the overvoltage is capacitively applied to the circuit by means of a capacitor.

7. Method according to claim 6, **characterised in that** at least one stage of an additional Marx generator is used as voltage source.

8. Method according to claim 6, **characterised in that** the overvoltage is caused by the charging process of the earth leakage capacitances of at least one subsequent stage in a Marx generator.

9. Method according to claim 6, **characterised in that** the overvoltage is caused by the charging process of the capacitive portion and/or the ohmic portion of a load impedance connected to the output of the Marx generator.

10. Method according to one of the preceding claims, **characterised in that** the switching of a spark gap is determined by optoelectronic means.

11. Method according to one of the preceding claims, **characterised in that** the switching of a spark gap is capacitively output and further processed by means of a coupled condenser.

## Revendications

1. Procédé de fonctionnement déclenché en continu d'un générateur de Marx, notamment de plusieurs générateurs de Marx au point de fonctionnement optimum sur une période prolongée pour la régulation de la pression et la détection de l'érosion des éclateurs des générateurs de Marx,
selon lequel
les éclateurs d'un générateur de Marx sont installés dans une tour de commutation avec une atmosphère de gaz isolant sous une pression réglable et/ou au moins l'une des deux calottes formant l'intervalle d'un éclateur étant réglable axialement,
procédé comprenant les étapes suivantes :
- pour le déclenchement, on combine sur au moins un éclateur d'un générateur de Marx, une surtension croissante avec en fonction du temps et se traduisant par la décharge disruptive de l'éclateur,
- on détermine la valeur de la surtension à l'instant de la décharge disruptive et on l'utilise pour réguler la pression dans la tour des éclateurs et/ou la distance entre les calottes,
- à partir de la relation entre la tension de décharge disruptive, la pression dans la tour de commutation et la distance entre les calottes de l'éclateur déclenché, on détermine la distance pour une tension de décharge disruptive connue et une pression connue et on l'utilise pour détecter l'érosion,
- dans le cas de calottes réglables, on détecte l'érosion en se fondant sur une mesure de course de déplacement en complément de la mesure de tension et de pression,
- pour le déclenchement défini dans le temps d'au moins deux générateurs de Marx, on mesure le retard à l'allumage de chaque générateur de Marx et on étage les signaux de déclenchement dans le temps de façon que les tensions de sortie ou les courants de sortie de tous les générateurs de Marx augmentent dans une largeur de bande de dispersion dépendant de la construction jusqu'aux instants respectivement souhaités.

2. Procédé selon la revendication 1,
**caractérisé en ce qu'**
on fait la moyenne de la surtension mesurée sur plusieurs allumages et on utilise cette valeur moyenne à la place d'une valeur de mesure isolée pour déterminer la distance.

3. Procédé selon les revendications 1 et 2,
**caractérisé en ce qu'**
on détermine la surtension non par une mesure de tension, mais par la mesure de la différence de temps entre le moment du déclenchement et la décharge disruptive de l'éclateur, la courbe de tension en fonction du temps étant connue.

4. Procédé selon les revendications 1 et 2,
**caractérisé en ce qu'**
on diminue le temps statistique de retard d'allumage des différents éclateurs par une pré-ionisation.

5. Procédé selon les revendications 1 et 2,
**caractérisé en ce qu'**
on injecte la surtension de manière inductive dans le circuit par l'intermédiaire d'un transformateur.

6. Procédé selon les revendications 1 et 2,
**caractérisé en ce qu'**
on injecte la surtension de manière capacitive dans le circuit par l'intermédiaire d'une capacité.

7. Procédé selon la revendication 6,
**caractérisé en ce que**
comme source de tension, on utilise au moins un étage d'un autre générateur de Marx.

8. Procédé selon la revendication 6,
**caractérisé en ce qu'**
on produit la surtension en chargeant des capacités parasites de masse d'au moins un étage suivant dans un générateur de Marx.

9. Procédé selon la revendication 6,
**caractérisé en ce qu'**
on produit la surtension en chargeant la partie capacitive et/ou la partie ohmique d'une impédance de charge reliée à la sortie du générateur de Marx.

10. Procédé selon l'une des revendications précédentes,
**caractérisé en ce qu'**
on détermine de manière optoélectronique, la décharge disruptive d'un éclateur.

11. Procédé selon l'une des revendications précédentes,
**caractérisé en ce qu'**
on découple la décharge disruptive d'un éclateur de manière capacitive par l'intermédiaire d'un condensateur de couplage et on poursuit le traitement.
